# EUROPÄISCHE PATENTSCHRIFT

(11) **EP 0 797 109 B1**
(45) Veröffentlichungstag und Bekanntmachung des Hinweises auf die Patenterteilung: **02.01.2002**
(21) Anmeldenummer: 97103359.2
(22) Anmeldetag: 28.02.1997
(51) Int. Cl.: G01V 8/10, G01V 8/20

(54) **Verfahren zum Betrieb einer Lichtschrankenanordnung**
Method for driving an optical barrier
Procédé de contrôle d'un barrière optique

(30) Priorität: 21.03.1996 DE 19611195
(43) Veröffentlichungstag der Anmeldung: 24.09.1997
(73) Patentinhaber: Leuze lumiflex GmbH + Co., 80993 München (DE)
(72) Erfinder: Haberer, Hermann, 80999 München (DE); Lehner, Werner, 82194 Gröbenzell (DE); Haberl, Paul, 80999 München (DE)
(74) Vertreter: von Bülow, Tam, Dr.

(56) Entgegenhaltungen:
- DE-A- 4 141 468
- DE-A- 4 224 784
- DE-C- 19 510 304
- US-A- 5 243 182

## Beschreibung

Die Erfindung bezieht sich auf ein Verfahren zum Betrieb einer Lichtschrankenanordnung, d.h. von Lichtschranken, Lichtgittern oder Lichtvorhängen.

Aus der DE 42 24 784 A1 ist bekannt, Störimpulse von Fremdlichtquellen dadurch "auszublenden", daß Sender und Empfänger so synchronisiert werden, daß innerhalb eines Zeitraumes, der kleiner ist als der Minimalabstand von üblichen Störlichtimpulsen, ein Doppelimpuls ausgesandt wird und der Empfänger nur zu den Zeitpunkten der Doppelimpulse aktiviert ist. Damit fällt mindestens einer der Doppelimpulse in die Pause des Störlichtes und der Empfänger kann diesen auswerten. Die Auswertung ist so ausgelegt, daß schon der Empfang einer Impulsgruppe des Doppelimpulses als ausreichend bewertet wird.

Dieses bekannte Verfahren ist zwar gut dazu geeignet, Störlichtimpulse von Fremdlichtquellen wie z. B. startenden Neonröhren, Lichtbogenschweißgeräten etc. zu eliminieren. Es versagt aber, wenn in einem Raum mehrere Geräte des gleichen Typs so aufgestellt sind, daß sie sich wechselseitig beeinflußen können. Durch Überreichweiten eines Lichtsenders, sei es in direkter Abstrahlung oder durch Reflexion an Gegenständen, kann es vorkommen, daß ein Empfänger Licht von einem nicht zu ihm gehörenden Sender empfängt. Trifft ein solcher "falscher" Lichtimpuls mit einem zu dem entsprechenden Empfänger gehörenden Nutzimpuls zusammen, so kann der Empfänger die üblicherweise kodierten Impulse nicht richtig auswerten und er wird ein Fehlersignal erzeugen. Dies führt bei sicherheitstechnischen Geräten in der Regel zu einem Abschalten der überwachten Maschine, wodurch die Verfügbarkeit der Maschine bei ungünstiger Aufstellung der Überwachungseinrichtungen dramatisch herabgesetzt wird. Im noch schlimmeren Fall kann ein Empfänger das von einem fremden Sender stammende Signal irrtümlich als "richtig" auswerten und dann ein Signal für "Schutzfeld frei" abgeben, obwohl dieses beispielsweise durch eine Person unterbrochen ist. Dies ist bei Schutzeinrichtungen für Maschinen nicht hinnehmbar.

Eine Lösung dieses Problems setzt zweierlei voraus, nämlich
1. jeder Empfänger muß das von dem ihm zugeordneten Sender ausgesandte Licht von Licht, das von Fremdsendern abgestrahlt wurde, unterscheiden können und
2. ein Empfänger darf durch Licht von einem Fremdsender nicht so gestört werden, daß er das vom zugehörigen Sender abgestrahlte Licht nicht richtig auswerten kann.

Eine Lösung dieses Problems könnte darin liegen, bei jedem Sender/Empfänger-Paar mit Licht unterschiedlicher Wellenlänge zu arbeiten, was durch entsprechende Farbfilter erreicht werden könnte. Fremdlicht von einem anderen Sender könnte das Farbfilter nicht passieren und somit weder fälschlicherweise einen "richtigen" Empfang vortäuschen noch den Empfänger für das auf seiner zugeordneten Wellenlänge liegende Licht sperren. Je mehr gleichartige Geräte in einem Raum aufgestellt sind, desto schmalbandiger müssen dann aber die Farbfilter werden, was nicht nur einen enormen Aufwand bedeutet sondern auch hohe Sendeleistungen fordern würde. Darüber hinaus müßte jedes Sender/Empfänger-Paar mit individuellen Farbfiltern bestückt werden und es müßte Sorge getragen werden, daß nicht zwei auf der gleichen Wellenlänge arbeitende Geräte im selben Raum aufgestellt werden, was hohen Organisationsaufwand mit sich bringt und beim Hersteller der Geräte und auch beim Benutzer einen hohen Lageraufwand bedingt, da die meisten Benutzer einige Reservegeräte auf Lager halten, damit bei Ausfall einer Überwachungseinrichtung nicht die Produktion längerfristig unterbrochen werden muß.

Eine weitere Möglichkeit bestünde darin, die Lichtstrahlen von Sender zum Empfänger so eng zu bündeln, daß aus einem anderen Winkel eingestrahltes Fremdlicht nicht zu den Empfangsdioden gelangt. Hierdurch lassen sich zwar graduelle Verbesserungen erzielen, der bauliche Aufwand für Abstimmungsmaßnahmen und Strahlenbündelung wird dann aber unverhältnismäßig groß.

Aus der DE 39 39 191 C2 ist es bekannt, bei mehrstrahligen Einweg-Lichtschranken Puls-Pausen-modulierte Impulse mit einer Kennung auszusenden und den Empfänger so mit dem Sender zu synchronisieren, daß die jeweiligen Empfangsdioden nur zu vorbestimmten Zeitpunkten aktiviert werden, zu denen der Sender die Impulse sendet. Somit wird für jedes Paar von Sendediode und zugeordneter Empfangsdiode synchron ein Zeitfenster geöffnet, innerhalb dessen die Signalübertragung erfolgt. Erweitert man diesen Gedanken auf mehrere Sender/Empfänger-Paare, so ließe sich das Problem der wechselseitigen Beeinflußung dadurch lösen, daß alle Sender/Empfänger-Paare miteinander so synchronisiert werden, daß sie immer gerade abwechselnd senden und somit der Nutzimpuls des einen Senders gerade in die Pausen der übrigen Sender fällt. Eine solche Synchronisation müßte aber von einer Zentraleinheit durchgeführt werden, die über Kabel mit allen anderen Einheiten verbunden ist. Eine Synchronisation über Lichtimpulse scheidet deswegen aus, weil die einzelnen Sender/Empfänger-Paare ja an sich so aufgestellt werden sollen, daß sie sich gegenseitig gerade nicht beeinflußen. Auch könnte der alle Geräte synchronisierende Lichtstrahl durch Personen, Fahrzeuge oder sonstige Gegenstände unterbrochen sein, so daß dieser Vorschlag ausscheidet.

Eine Verbesserung der Selektivität könnte entsprechend dem Gedanken der DE 31 19 876 auch durch Überlagerung mehrerer Kodierungsarten erfolgen, beispielsweise indem man hochfrequent moduliertes Licht verwendet oder eine selektive Empfangschaltung. Diese Methode ist aber nur dann praktikabel, wenn es sich um eine einstrahlige bis wenig strahlige Lichtschranke handelt, da die Einschwingzeiten von selektiven Verstärkern die Zykluszeit der Lichtschranke verlängern würden. Außerdem muß bei dieser Methode der Sender relativ lange moduliert eingeschaltet bleiben, was zu langen Zykluszeiten und einer hohen Strombelastung führt.

Lichtschranken, die Impulsgruppen kodierten Lichtes aussenden sind auch aus der DE 38 03 033 A1, DE 36 05 885 bekannt. Eine Synchronisation zwischen Lichtsender und Lichtempfänger ist auch aus der EP 0 397 757 B1, EP 0 345 361 A1 und US 4,266,124 bekannt.

Aufgabe der vorliegenden Erfindung ist es, die genannten Nachteile zu überwinden und ein Verfahren vorzuschlagen, durch welches die Störfestigkeit einer Lichtschranke, eines Lichtgitters oder eines Lichtvorhanges in Bezug auf die gegenseitige Beeinflußung durch andere ähnliche oder baugleiche Geräte verbessert wird. Diese Aufgabe wird durch die im Anspruch 1 angegebenen Merkmale gelöst. Vorteilhafte Ausgestaltungen und Weiterbildungen der Erfindung sind den Unteransprüchen zu entnehmen.

Das Lösungsprinzip der vorliegenden Erfindung besteht darin, die Dauer der Impulsgruppen und der Pausen zwischen diesen für die jeweiligen Sender/Empfänger-Paare so festzulegen, daß mit Sicherheit eine der Impulsgruppen eines Doppelimpulses eines Senders vollständig in eine Pause des anderen Senders bzw. der anderen Sender fällt. Die verschiedenen Sender müssen dabei nicht miteinander synchronisiert sein und können durch freilaufende Oszillatoren getaktet werden. Selbst wenn die Oszillatorfrequenzen der verschiedenen Sender voneinander abweichen und die Oszillatoren daher auch nicht phasenstarr zueinander schwingen, ist mit der Erfindung trotzdem sicher gestellt, daß mindestens eine Impulsgruppe eines Doppelimpulses vollständig in eine Pause des anderen Senders bzw. der anderen Sender fällt. Maßgeblich ist daher nicht die Langzeitstabilität der Oszillatoren sondern nur deren Kurzzeitverhalten innerhalb einer Periodendauer der Doppelimpulse. Selbst relativ ungenau arbeitende Oszillatoren arbeiten in so kurzen Zeiträumen von nur einigen Mikro- oder Millisekunden ausreichend stabil, so daß die Bedingungen für die Länge der Impulsgruppen und die Pausen problemlos eingehalten werden können.

Nach einer Ausgestaltung der Erfindung sind die Zeitdauer der Impulsgruppen und die Pausen zwischen diesen so festgelegt, daß sie folgenden Bedingungen genügen:
1. a > p
2. c > a + 2p
3. b > c + 2p
4. d > a + 2p
wobei
- a =: Pause zwischen den beiden Impulsgruppen eines Doppelimpulses des einen Senders
- c =: Pause zwischen den beiden Impulsgruppen eines Doppelimpulses des anderen Senders
- p =: Dauer der Impulsgruppen
- c =: Pause zwischen aufeinanderfolgenden Doppelimpulsen des einen Senders und
- d =: Pause zwischen aufeinanderfolgenden Doppelimpulsen des anderen Senders.

Sind diese vier Bedingungen eingehalten, so ist auch bei völlig asynchronem Betrieb von zwei Sendern immer sichergestellt, daß mindestens eine Impulsgruppe eines Senders vollständig in eine Pause des anderen Senders fällt.

Nach einer Weiterbildung der Erfindung sind die Zeitdauer der Impulsgruppen und die Pausen für jedes Sender/Empfänger-Paar einstellbar bzw. vom Benutzer programmierbar, so daß bei nachträglicher Aufstellung eines zusätzlichen Sender/Empfänger-Paares die entsprechenden Zeitdauern an die schon vorhandenen Geräte angepaßt werden können.

Nach einer Weiterbildung der Erfindung hat jede Impulsgruppe eines Senders eine Kennung, die sich von den Kennungen aller übrigen Geräte unterscheidet (Kanalkennung). Nach einer anderen Weiterbildung der Erfindung haben die beiden Impulsgruppen eines Doppelimpulses eine weitere Kennung, die anzeigt, ob es sich um die erste oder zweite Impulsgruppe des Doppelimpulses handelt.

Nach einer anderen Weiterbildung der Erfindung haben bei mehrstrahligen Lichtschranken die Impulsgruppen eines ausgewählten Doppelimpulses, vorzugsweise die des im Zyklus ersten Doppelimpulses, eine zusätzliche Kennung, die den entsprechenden Lichtstrahl von allen übrigen Lichtstrahlen des selben Senders unterscheiden läßt. Diese Kennung wird zur Synchronisation zwischen Sender und zugeordnetem Empfänger verwendet.

Nach einer noch weiteren Ausgestaltung der Erfindung haben alle Impulsgruppen noch zusätzlich ein Startbit.

Nach einer anderen Weiterbildung der Erfindung können bei mehrstrahligen Lichtschranken die Doppelimpulse zyklisch ohne besondere Pause am Ende eines Zyklus aufeinanderfolgen.

Um die Störfestigkeit weiter zu erhöhen ist nach einer weiteren Ausgestaltung der Erfindung vorgesehen, eine Mehrfachauswertung vorzusehen, dergestalt, daß ein gestörter Betrieb erst dann signalisiert wird, wenn mehrere aufeinanderfolgende Doppelimpulse nicht richtig erkannt werden. Ansonsten könnte es vorkommen, daß durch zusätzliche Störlichtquellen gerade zu dem Moment, in dem an sich eine richtige Impulsgruppe empfangen werden könnte, der Empfänger durch das Störlicht gestört ist. Die Mehrfachauswertung muß natürlich innerhalb solcher Zeit abgeschlossen sein, daß die Reaktionszeit des gesamten Systems bis hin zum Stillsetzen der überwachten Maschine noch eingehalten ist.

Nach einer bevorzugten Weiterbildung der Erfindung ist bei dieser Mehrfachauswertung ein variabler Schwellwert vorgesehen, der festlegt, wieviele Fehlerzustände in ununterbrochener oder unterbrochener Folge auftreten dürfen, bevor eine Strahlunterbrechung signalisiert und gegebenenfalls eine überwachte Maschine stillgesetzt wird. Dieser Schwellwert hängt bei mehrstrahligen Lichtschranken von der Anzahl der Strahlen ab sowie von der erwähnten Reaktionszeit des Systems. Dieser Schwellwert ist dahingehend variabel, daß er die "Vorgeschichte" berücksichtigt und bei längerem absolut fehlerfreien Betrieb eine größere Anzahl von Fehlerzuständen zuläßt als bei zuvor schon gestörtem Betrieb.

Nach einer Weiterbildung der Erfindung wird dies dadurch realisiert, daß bei jeder "richtig" erkannten Impulsgruppe ein Zähler inkrementiert und bei jeder falsch erkannten Impulsgruppe dekrementiert wird. Das Inkrementieren erfolgt bis zu einem fest vorgegebenen Maximalwert, der die Reaktionszeit des Systems und die Anzahl der Strahlen bzw. die Zyklusdauer berücksichtigt. Ist der Inhalt des Zählers auf einen vorbestimmten Wert, beispielsweise von null dekrementiert, so wird eine Strahlunterbrechung angenommen.

Nach einer anderen Weiterbildung der Erfindung sind an Sender und Empfänger eine Kanal- oder Gerätenummer programmierbar, durch die auch gleichzeitig mindestens die Kanalkennung und die Zeitdauer der Pausen zwischen einzelnen Impulsgruppen festgelegt werden. Der Benutzer muß bei jedem zugehörigen Sender- und Empfänger-Paar nur noch dieselbe Kanal- oder Gerätenummer eingeben, was beispielsweise über Dipschalter, Steckverbinder (sogenannte Jumper), eine Kodierkarte, ein externes Kodiergerät oder einen Kodierstecker erfolgen kann. Dabei sollte der Benutzer darauf achten, daß innerhalb eines Raumes nicht zweimal dieselbe Kanal- oder Gerätenummer vergeben wird. Damit können alle Sender und Empfänger absolut baugleich sein, was den Produktions- und Lageraufwand beträchtlich verringert. Auch kann der Benutzer ohne größerem Aufwand eine defekte Komponente wie z. B. einen Sender oder einen Empfänger auswechseln und muß ihn lediglich auf die andere Komponente programmieren.

Nach einer Weiterbildung der Erfindung ist vorgesehen, daß bei der ersten Aufstellung jeder Empfänger automatisch einen freien Kanal sucht, wobei während dieser Zeit sein zugehöriger Sender noch abgeschaltet ist. Hat der Empfänger einen freien Kanal gefunden, so teilt er dies über eine vom Empfänger zum Sender laufende Übertragungsstrecke mit und das zugehörige Sender/Empfänger-Paar synchronisiert sich auf diesen Kanal auf.

Um zu verhindert, daß sich der Sender auf einen "falschen" Kanal aufsynchronisiert ist vorzugsweise vorgesehen, daß jedes zugeordnete Sender/Empfänger-Paar eine individuelle Gerätenummer hat. Diese Gerätenummer wird zwischen Sender und Empfänger ausgetauscht, beispielsweise elektrisch über Kabel, optisch über Lichtstrahlen oder über Funk. Diese Gerätenummer ist wiederum programmierbar durch die oben beschriebenen Maßnahmen.

Im folgenden wird die Erfindung anhand eines Ausführungsbeispieles im Zusammenhang mit der Zeichnung ausführlicher erläutert. Es zeigt:
- Fig. 1: ein Zeitdiagramm von jeweils zwei Doppelimpulsen für zwei Kanäle;
- Fig. 2a) bis 2d): weitere Zeitdiagramme zur Veranschaulichung der Zeitbedingungen nach dem erfindungsgemäßen Verfahren; und
- Fig. 3: ein weiteres Zeitdiagramm der Doppelimpulse für zwei Kanäle über einen längeren Zeitraum.

Ein erster Sender sendet auf einem Kanal 1 Impulsgruppen 1A, 1B der zeitlichen Länge p aus, wobei zwischen diesen beiden eine Pause der Dauer a liegt, die länger ist als die Dauer p. Die beiden Impulse 1A und 1B zusammen bilden einen Doppelimpuls L11. Nach dem Ende der zweiten Impulsgruppe 1B folgt eine Pause b, worauf ein weiterer Doppelimpuls L12 mit den beiden Impulsgruppen 2A und 2B folgt, die wiederum dieselbe Zeitdauer p und dieselbe Pause zwischen sich der Länge a haben. Die Impulse 1A, 1B unterscheiden sich von den Impulsen 2A, 2B durch eine Kennung. Bei mehrstrahligen Lichtschranken hat vorzugsweise der im Zyklus erste Lichtstrahl die entsprechende Kennung, die ihn als ersten Lichtstrahl bezeichnet, während alle übrigen darauffolgenden Lichtstrahlen dieselbe Kennung wie der zweite Lichtstrahl haben.

Ein zweiter Sender sendet auf Kanal 2 in analoger Weise, wobei die einzelnen Impulsgruppen ebenfalls dieselbe Zeitdauer p wie die Impulsgruppen des Kanales 1. Der Abstand zwischen zwei Impulsgruppen 1A und 1B eines ersten Doppelimpulses L21 beträgt c, wobei c größer ist als die Dauer der Doppelimpulse des Kanales 1, also größer als a + 2p. Die Pause zwischen aufeinanderfolgenden Doppelimpulsen L21 und L2 2 beträgt d, das ebenfalls größer ist als die Dauer eines Doppelimpulses des Kanales 1. Es gilt also d > a + 2p.

Schließlich ist die Dauer b zwischen zwei Doppelimpulsen des Kanales 1 wiederum größer zu wählen als die Dauer eines Doppelimpulses des Kanales 2. Es gilt also b > c + 2p. Auch im zweiten Kanal ist die Kennung des ersten Strahles von der der übrigen Strahlen verschieden. Darüber hinaus sind die Kennungen der Impulsgruppen des Kanales 1 von denen des Kanales 2 verschieden, so daß jeder Empfänger eindeutig erkennen kann, ob das empfangene Licht von seinem zugeordneten Kanal oder einem fremden Kanal stammt.

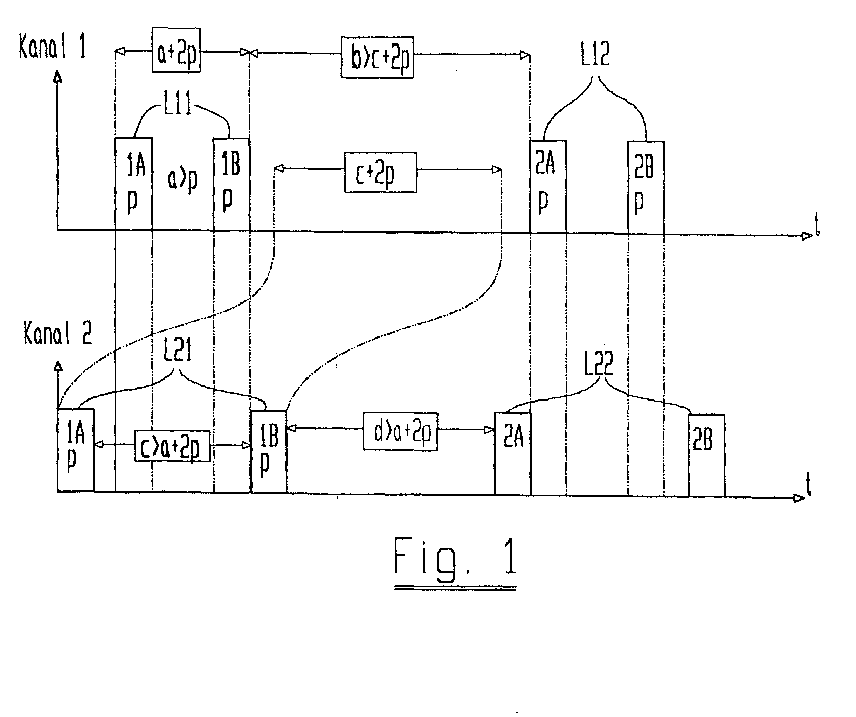

Aus Fig. 1 ist klar ersichtlich, daß der Doppelimpuls L11 in die Pause zwischen den Impulsgruppen 1A und 1B des Doppelimpulses L21 paßt. Weiterhin ist ersichtlich, daß der Doppelimpuls L21 in die Pause zwischen den Doppelimpulsen L11 und L12 des Kanales 1 paßt. Um bei zwei Kanälen mit Sicherheit zu erreichen, daß mindestens eine Impulsgruppe eines Doppelimpulses eines Kanales vollständig in eine Pause des anderen Kanales paßt, müssen also folgende vier Bedingungen erfüllt sein:
1. a > p
2. c > a + 2p
3. b > c + 2p
4. d > a + 2p

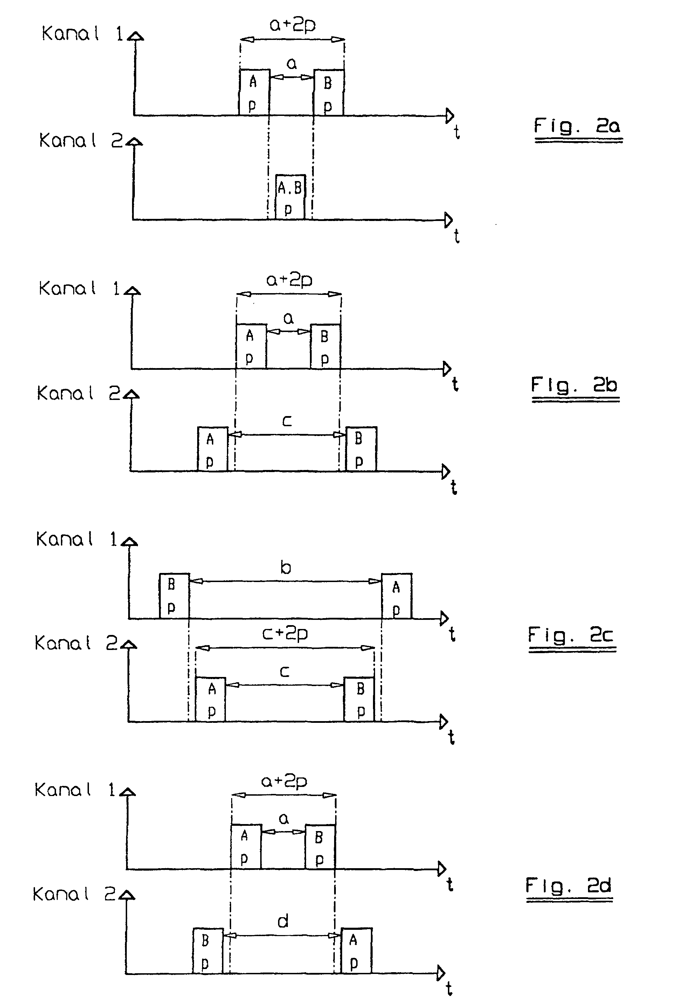

Diese vier Bedingungen seien nachfolgend im Bezug auf die Fig. 2a) bis 2d) noch einmal verdeutlicht. Die Bedingung 1 stellt sicher, daß eine Impulsgruppe des Kanales 2 nicht beide Impulsgruppen des Kanales 1 teilweise überlappt. (Fig. 2a))

Die zweite Bedingung c > a + 2p stellt sicher, daß nicht gleichzeitig die erste Impulsgruppe des Kanales 1 die erste Impulsgruppe des Kanales 2 und die zweite Impulsgruppe des Kanales 1 die zweite Impulsgruppe des Kanales 2 überlappt. (Fig. 2b))

Die dritte Bedingung b > c + 2p stellt sicher, daß nicht in entsprechender Weise gleichzeitig die zweite Impulsgruppe eines Doppelimpulses des ersten Kanales die erste Impulsgruppe eines Doppelimpulses des zweiten Kanales und die erste Impulsgruppe eines darauffolgenden Doppelimpulses des ersten Kanales die zweite Impulsgruppe eines Doppelimpulses des zweiten Kanales überdeckt. (Fig. 2c))

Schließlich stellt die vierte Bedingung d > a + 2p sicher, daß sich nicht die beiden Impulsgruppen eines Doppelimpulses des ersten Kanales mit der zweiten Impulsgruppe eines Doppelimpulses des zweiten Kanales und der ersten Impulsgruppe eines darauffolgenden Doppelimpulses des zweiten Kanales überdecken.

Somit ist, wenn diese vier Bedingungen eingehalten sind, in jedem Falle sicher gestellt, daß mindestens eine Impulsgruppe eines Doppelimpulses eines Kanales vollständig in eine Pause zwischen den Impulsgruppen des zweiten Kanales fällt.

Alle Zeitdauern sind nur von den Größen p und a abhängig, wobei p vorzugsweise für alle Kanäle gleichlang gewählt ist. Auch die Pausen a, b, c und d sind während des Betriebes starr. Sie sind jedoch vor Aufnahme des Betriebes für jedes Sender/Empfänger-Paar voreinstellbar. Die einzelnen Zeitwerte sollen so voreingestellt werden, daß innerhalb der Reaktionszeit des Systems jedes Kanales ein Doppelimpuls des zugehörigen Senders mindestens einmal vollständig empfangen werden kann. Die Reaktionszeit des Systems ist dabei die Zeit zwischen Auftreten eines bestimmten Zustandes wie z. B. Auftreten einer Strahlunterbrechung und Abschluß der dadurch auszulösenden Maßnahme wie z. B. Stillsetzen einer Maschine.

Werden mehr als zwei Sender/Empfänger-Paare in einem Raum gleichzeitig betrieben, so gelten die oben genannten Bedingungen in analoger Weise, d. h. im Verhältnis zwischen Kanal 2 und Kanal 3 gelten die gleichen Beziehung wie im Verhältnis zwischen Kanal 1 und Kanal 2.

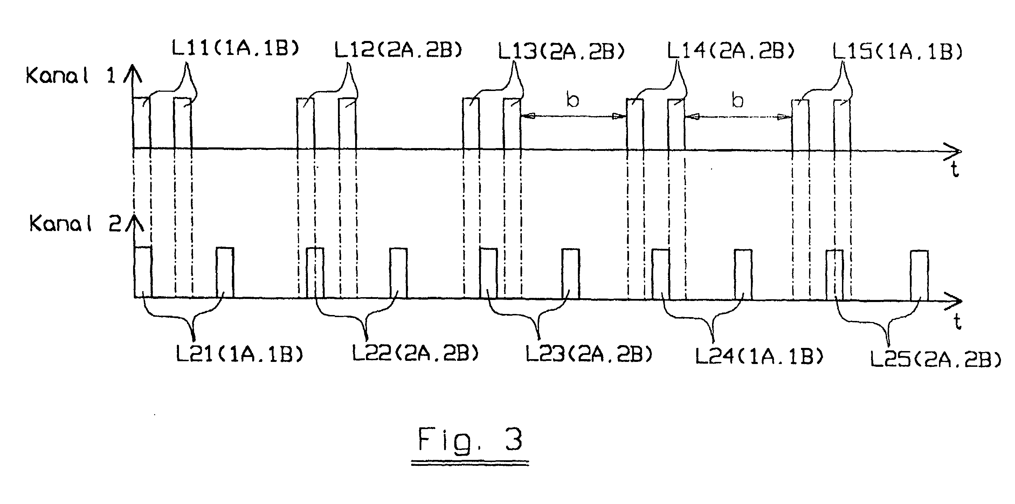

Fig. 3 zeigt den Zeitverlauf von Doppelimpulsen L11 bis L15 im Kanal 1 und L21 bis L25 im Kanal 2. In Klammern hinter dem Bezugszeichen der Doppelimpulse sind die Impulsgruppen angegeben, aus denen sich die Doppelimpulse zusammensetzen. Die erste Impulsgruppe 1A der Doppelimpulse L11 und L12 beginne dabei synchron, d. h. die beiden Impulsgruppen überlappen sich vollständig. Die zweiten Impulsgruppen 1B der Doppelimpulse L11 und L21 sind dagegen vollständig überlappungsfrei. Beim zweiten Doppelimpuls L12 bzw. L22 überlappen sich ersten Impulsgruppen 2A und 2B noch teilweise, während auch hier die zweiten Impulsgruppen dieses Doppelimpulses überlappungsfrei sind. Bei den dritten und vierten Doppelimpulsten L13, L23; L14, L24 findet keinerlei Überlappung statt. Bei den fünften Doppelimpulsen überlappt die zweite Impulsgruppe des Doppelimpulses L15 die erste Impulsgruppe 2A des Doppelimpulses L25. In keinem Falle überlappen sich aber beide Impulsgruppen eines Doppelimpulses mit Impulsgruppen des anderen Kanales.

Zu weiteren Verbesserungen der Störsicherheit kann eine Mehrfachauswertung über mehrere Sendezyklen strahlweise durchgeführt werden. Diese Mehrfachauswertung wird so vorgenommen, daß der korrekte Empfang einer Impulsgruppe eines Strahles einen Zähler inkrementiert und ein nicht korrekter Empfang diesen Zähler dekrementiert. Ein Fehlersignal bzw. ein Signal für einen unterbrochenen Lichtstrahl wird erst dann abgegeben, wenn der Inhalt des jeweiligen Zählers einen vorgegebenen Wert unterschreitet. Somit wird dieses Fehlersignal nur dann ausgegeben, wenn, abhängig von der Vorgeschichte, in mehreren vorhergehenden Zyklen kein korrekter Lichtempfang vorlag. Das Inkrementieren des Zählers erfolgt nur bis zu einem vorgegebenen Grenzwert, der auf die Reaktionszeit des Systems und bei mehrstrahligen Lichtschranken auch auf die Zahl der Strahlen abgestimmt ist. Ist dieser Grenzwert beispielsweise auf 10 festgelegt, was hier eine rein willkürlich herausgegriffene Zahl darstellt, so wird der Inhalt des Zählers nur bis zum Wert 10 inkrementiert und bleibt bei diesem Zählinhalt stehen, auch wenn weitere "richtige" Impulsgruppen empfangen werden. Bei jeder nicht richtig empfangenen Impulsgruppe wird der Zählinhalt um 1 herabgesetzt. Liegt die Ansprechschwelle beim Zählinhalt 0, so wird also spätestens nach zehn Zyklen ein Fehlersignal ausgegeben, wenn bei zehn aufeinanderfolgenden Zyklen ein Fehler auftrat. Damit ist die Ansprechschwelle für alle Fehlermeldungen variabel und hängt von der "Vorgeschichte" ab. Waren beispielsweise bei anfänglich ungestörtem Betrieb (Zählinhalt = 10) neun aufeinanderfolgende Impulsgruppen gestört, so wird die zehnte gestörte Impulsgruppe die Fehlermeldung auslösen. Jede einwandfrei empfangene Impulsgruppe erhöht dann wieder die Ansprechschwelle. Mit dieser Maßnahme wird die Störfestigkeit erhöht, insbesondere in Bezug auf Störlicht von Fremdlichtquellen wie z. B. Stroposkoplampen, zündenden Neonröhren, Lichtbogenschweißgeräten etc., die ja gerade in den Zeitraum fallen können, in denen eine Impulsgruppe unbeeinflußt von anderen Lichtschranken einwandfrei empfangen werden müßte. Die Ansprechzeit wird dadurch zwar erhöht, aber auch gleichzeitig die Verfügbarkeit. Nach einer Weiterbildung der Erfindung kann auch vorgesehen sein, daß die Schritte zum Inkrementieren und zum Dekrementieren der Zähler unterschiedlich gewählt sind. Beispielsweise kann jeder richtig empfangene Impuls den Zähler um den Wert 1 inkrementieren, während jede gestörte, d. h. nicht richtig empfangene Impulsgruppe den Zähler um einen größeren Wert von beispielsweise 2 dekrementiert. Hierdurch wird zwar die Verfügbarkeit etwas verringert, dafür die Reakionszeit des Systems verkürzt.

## Patentansprüche

1. Verfahren zum Betrieb einer Lichtschrankenanordnung, die mindestens zwei jeweils synchron arbeitende Sender/Empfänger-Paare aufweist, wobei jeder der beiden Sender je eine spezifische Kennung aufweisende Lichtsignale in Form von je durch eine Pause b bzw. d getrennten Doppelimpulsen (L11, L12, L13, L14, L15, L21, L22, L23, L24, L25) , bestehend aus je durch je eine Pause a bzw. c getrennten zwei Impulsgruppen (1A, 1B, 2A, 2B), aussendet und jeder Empfänger ein Lichtsignal des zugehörigen Senders dann als korrekt empfangen bewertet, wenn mindestens eine der beiden Impulsgruppen (1A, 1B, 2A, 2B) mit Hilfe der zugehörigen Kennung als gültig erkannt wurde, bei dem die Dauer p der Impulsgruppen (1A, 1B, 2A, 2B) und die Pausen a bzw. c zwischen diesen so festgelegt sind, daß höchstens eine Impulsgruppe (1A, 1B, 2A, 2B) eines Doppelimpulses (L11, L12, L13, L14, L15, L21, L22, L23, L24, L25) des einen Senders von einer Impulsgruppe (1A, 1B, 2A, 2B) eines Doppelimpulses (L11, L12, L13, L14, L15, L21, L22, L23, L24, L25) des anderen Senders überlagert wird.

2. Verfahren nach Anspruch 1, **dadurch gekennzeichnet, daß** für die Dauer p der Impulsgruppen (1A, 1B, 2A, 2B) und die Pausen a, b, c und d folgende Beziehungen gelten:
1. a > p
2. c > a + 2p
3. b > c + 2p
4. d > a + 2p.

3. Verfahren nach Anspruch 2, **dadurch gekennzeichnet, daß** die Dauer p der Impulsgruppen (1A, 1B, 2A, 2B) und die Pausen a, b, c, d zwischen den Impulsgruppen (1A, 1B, 2A, 2B) für jedes Sender/Empfänger-Paar einstellbar sind.

4. Verfahren nach einem der Ansprüche 1 bis 3, **dadurch gekennzeichnet, daß** die Impulsgruppen (1A, 1B, 2A, 2B) mit einer Kennung kodiert sind, die für jedes Sender/Empfänger-Paar verschieden ist.

5. Verfahren nach einem der Ansprüche 1 bis 4, **dadurch gekennzeichnet, daß** die beiden Impulsgruppen (1A, 1B, 2A, 2B) jedes Doppelimpulses (L11, L12, L13, L14, L15, L21, L22, L23, L24, L25) mit einer Kennung kodiert sind, die anzeigt, ob es sich um die erste oder zweite Impulsgruppe (1A, 1B, 2A, 2B) des jeweiligen Doppelimpulses (L11, L12, L13, L14, L15, L21, L22, L23, L24, L25) handelt.

6. Verfahren nach einem der Ansprüche 1 bis 5, **dadurch gekennzeichnet, daß** jeder Sender seine Doppelimpulsgruppen zyklisch aussendet.

7. Verfahren nach einem der Ansprüche 1 bis 5, **dadurch gekennzeichnet, daß** bei mehrstrahligen, zyklisch arbeitenden Lichtschranken als Lichtschrankenanordnung die Impulsgruppen (1A, 1B, 2A, 2B) des im Zyklus ersten Doppelimpulses (L11, L12, L13, L14, L15, L21, L22, L23, L24, L25) eine von allen übrigen Impulsgruppen (1A, 1B, 2A, 2B) der weiteren Doppelimpulse (L11, L12, L13, L14, L15, L21, L22, L23, L24, L25) des Sender/Empfänger-Paares unterschiedliche Kennung aufweisen.

8. Verfahren nach Anspruch 6 oder 7, **dadurch gekennzeichnet, daß** die Impulsgruppen (1A, 1B, 2A, 2B) für jedes Lichtsignal jedes Senders für mehrere aufeinanderfolgende Zyklen ausgewertet werden und ein Fehlersignal erst dann erzeugt wird, wenn in einer vorbestimmten Anzahl von aufeinanderfolgenden Zyklen eine vorbestimmte Anzahl von Fehlerzuständen aufgetreten ist.

9. Verfahren nach Anspruch 8, **dadurch gekennzeichnet, daß** die vorgegebene Anzahl von ausgewerteten Zyklen und die vorgegebene Anzahl von Fehlerzuständen, nach der ein Fehlersignal erzeugt wird, abhängig gemacht werden kann
- von der Anzahl der zuvor korrekt empfangenen
- der Anzahl der zuvor nicht korrekt empfangenen Impulsgruppen (1A, 1B, 2A, 2B)
- von der Anzahl der Lichtsignale,
- der Reaktionszeit des Sender/Empfänger-Paares und
- einer von diesem überwachten Maschine.

10. Verfahren nach Anspruch 9, **dadurch gekennzeichnet, daß** eine Mehrfachauswertung dadurch erfolgt, daß jeder "richtig" empfangene Doppelimpuls (L11, L12, L13, L14, L15, L21, L22, L23, L24, L25) einen Zähler bis zu einem festvorgegebenen Maximalwert inkrementiert und jeder "unrichtig" empfangene Doppelimpuls (L11, L12, L13, L14, L15, L21, L22, L23, L24, L25) den Zähler dekrementiert, wobei ein Fehlersignal dann ausgelöst wird, wenn der Zählinhalt unter einen vorgegebenen Schwellwert dekrementiert ist.

11. Verfahren nach Anspruch 10, **dadurch gekennzeichnet, daß** das Inkrementieren und Dekrementieren des Zählers in unterschiedlichen Stufen erfolgt.

12. Verfahren nach einem der Ansprüche 1 bis 11, **dadurch gekennzeichnet, daß** jedes Sender/Empfänger-Paar eine programmierbare Gerätenummer enthält, durch die die Dauer der Impulsgruppen (1A, 1B, 2A, 2B) und die Dauer der Pausen zwischen diesen festgelegt sind.

13. Verfahren nach einem der Ansprüche 1 bis 12, **dadurch gekennzeichnet, daß** jeder Empfänger bei erster Inbetriebnahme eine automatische Kanalsuche nach einem freien Kanal durchführt, anschließend dem ihm zugeordneten Sender eine Information über einen freien Kanal übermittelt und darauf das zugeordnete Sender/Empfänger-Paar sich auf diesen freien Kanal aufsynchronisiert, wobei sich das Sender/Empfänger-Paar über einen Shake-Hand-Betrieb wechselseitig als zusammengehörig identifiziert.

## Claims

1. A method for operation of a photoelectric barrier that comprises at least two pairs of transmitters/receivers each operating synchronously, wherein each of the two transmitters transmits a light signal having a specific identifier, said signal being in the form of a double pulse (L11, L12, L13, L14, L15, L21, L22, L23, L24, L25) separated by a pause b and/or d, said double pulse consisting of two pulse groups (1A, 1B, 2A, 2B) each separated by a pause a and/or c, respectively, and each receiver receives and evaluates a light signal of the associated transmitter as correctly received when at least one of the two pulse groups (1A, 1B, 2A, 2B) is recognized as valid by means of the associated identifier, in which the duration p of the pulse groups (1A, 1B, 2A, 2B) and the pauses a and/or c between them are established so that at most one pulse group (1A, 1B, 2A, 2B) of one double pulse (L11, L12, L13, L14, L15, L21, L22, L23, L24, L25) of the one transmitter is superimposed with one pulse group (1A, 1B, 2A, 2B) of one double pulse (L11, L12, L13, L14, L15, L21, L22, L23, L24, L25) of the other transmitter.

2. The method according to claim 1 wherein the following relations apply for the period p of the pulse groups (1A, 1B, 2A, 2B) and the pauses a, b, c and d:
1. a > p
2. c > a + 2p
3. b > c + 2p
4. d > a + 2p.

3. The method according to claim 2 wherein the period p of the pulse groups (1A, 1B, 2A, 2B) and the pauses a, b, c, d between the pulse groups (1A, 1B, 2A, 2B) are adjustable for each transmitter/receiver pair.

4. The method according to one of the claims 1 to 3 wherein the pulse groups (1A, 1B, 2A, 2B) are coded with an identifier which is different for each transmitter/receiver pair.

5. The method according to one of the claims 1 to 4 wherein the two pulse groups (1A, 1B, 2A, 2B) of each double pulse (L11, L12, L13, L14, L15, L21, L22, L23, L24, L25) are coded with an identifier which indicates whether it pertains to the first or second pulse group (1A, 1B, 2A, 2B) of the particular double pulse (1A, 1B, 2A, 2B).

6. The method according to one of the claims 1 to 5 wherein each transmitter transmits its double pulse groups cyclically.

7. The method according to one of the claims 1 to 5 wherein in the case of multi-beam, cyclically operating lightbeam barriers as optoelectronic machine guards, the pulse groups (1A, 1B, 2A, 2B) of the first double pulse (L11, L12, L13, L14, L15, L21, L22, L23, L24, L25) in the cycle have an identifier different from all other pulse groups (1A, 1B, 2A, 2B) of the additional double pulses (L11, L12, L13, L14, L15, L21, L22, L23, L24, L25) of the transmitter/receiver pair.

8. The method according to claim 6 or 7 wherein the pulse groups (1A, 1B, 2A, 2B) for each light signal of each transmitter are evaluated for several sequential cycles and a fault signal is then generated when a predetermined number of fault states occurs in a predetermined number of sequential cycles.

9. The method according to claim 8 wherein the specified number of evaluated cycles and the specified number of fault states after which a fault signal is generated, can be made dependent
- on the number of pulse groups (1A, 1B, 2A, 2B) correctly received beforehand,
- on the number of pulse groups (1A, 1B, 2A, 2B) not correctly received beforehand,
- on the number of light signals,
- on the reaction time of the transmitter/receiver pair, and
- on a machine monitored by it.

10. The method according to claim 9 wherein a multiple evaluation takes place in that each "correctly" received double pulse (L11, L12, L13, L14, L15, L21, L22, L23, L24, L25) increments a counter up to a previously specified maximum value and each "incorrectly" received double pulse (L11, L12, L13, L14, L15, L21, L22, L23, L24, L25) decrements the counter, wherein a fault signal is triggered when the counter is decremented below a specified threshold value.

11. The method according to claim 10 wherein the incrementing and decrementing of the counter takes place in different steps.

12. The method according to one of the claims 1 to 11 wherein each transmitter/receiver pair contains a programmable device number through which the duration of the pulse groups (1A, 1B, 2A, 2B) and the duration of the pauses between them are specified.

13. The method according to one of the claims 1 to 12 wherein each receiver upon initial operation carries out an automatic channel search for a free channel, subsequently passes information about a free channel to its associated transmitter, and subsequently synchronizes the associated transmitter/receiver pair to this free channel, wherein the transmitter/receiver pair uses a handshake operation to identify each other.

## Revendications

1. Procédé de contrôle d'une barrière optique qui présente au moins deux couples émetteur/récepteur qui fonctionnent respectivement de façon synchrone, chacun des deux émetteurs émettant des signaux lumineux qui ont chacun une caractéristique spécifique et qui se présentent sous forme d'impulsions doubles (L11, L12, L13, L14, L15, L21, L22, L23, L24, L25) séparées respectivement par un intervalle b ou d et composées de respectivement deux trains d'impulsions (1A, 1B, 2A, 2B) séparés respectivement par un intervalle a ou c, et chaque récepteur évaluant un signal lumineux de l'émetteur correspondant comme reçu correctement si au moins l'un des deux trains d'impulsions (1A, 1B, 2A, 2B) a été reconnu valide à l'aide de la caractéristique correspondante, procédé dans lequel la durée p des trains d'impulsions (1A, 1B, 2A, 2B) et les intervalles a et c entre ceux-ci sont fixés de telle sorte que tout au plus un train d'impulsions (1A, 1B, 2A, 2B) d'une impulsion double (L11, L12, L13, L14, L15, L21, L22, L23, L24, L25) de l'un des émetteurs est brouillé par un train d'impulsions (1A, 1B, 2A, 2B) d'une impulsion double (L11, L12, L13, L14, L15, L21, L22, L23, L24, L25) de l'autre émetteur.

2. Procédé selon la revendication 1, **caractérisé en ce que** pour la durée p des trains d'impulsions (1A, 1B, 2A, 2B) et les intervalles a, b, c et d on applique les relations suivantes :
1. a > p
2. c > a + 2p
3. b > c + 2p
4. d > a + 2p.

3. Procédé selon la revendication 2, **caractérisé en ce que** la durée p des trains d'impulsions (1A, 1B, 2A, 2B) et les intervalles a, b, c, d entre les trains d'impulsions (1A, 1B, 2A, 2B) sont réglables pour chaque couple émetteur/récepteur.

4. Procédé selon l'une des revendications 1 à 3, **caractérisé en ce que** les trains d'impulsions (1A, 1B, 2A, 2B) sont codés avec une caractéristique qui est différente pour chaque couple émetteur/récepteur.

5. Procédé selon l'une des revendications 1 à 4, **caractérisé en ce que** les deux trains d'impulsions (1A, 1B, 2A, 2B) de chaque impulsion double (L11, L12, L13, L14, L15, L21, L22, L23, L24, L25) sont codés avec une caractéristique qui indique s'il s'agit du premier ou du deuxième train d'impulsions (1A, 1B, 2A, 2B) de l'impulsion double en question (L11, L12, L13, L14, L15, L21, L22, L23, L24, L25).

6. Procédé selon l'une des revendications 1 à 5, **caractérisé en ce que** chaque émetteur émet par cycles ses trains d'impulsions doubles.

7. Procédé selon l'une des revendications 1 à 5, **caractérisé en ce que** dans le cas d'une barrière optique sous forme de barrières lumineuses à plusieurs faisceaux et à fonctionnement cyclique, les trains d'impulsions (1A, 1B, 2A, 2B) de l'impulsion double (L11, L12, L13, L14, L15, L21, L22, L23, L24, L25) qui est la première dans le cycle présentant une caractéristique différente de tous les trains d'impulsions restants (1A, 1B, 2A, 2B) des impulsions doubles ultérieures (L11, L12, L13, L14, L15, L21, L22, L23, L24, L25) du couple émetteur/récepteur.

8. Procédé selon la revendication 6 ou 7, **caractérisé en ce que** les trains d'impulsions (1A, 1B, 2A, 2B) sont analysés pour chaque signal lumineux de chaque émetteur pour plusieurs cycles successifs et qu'un signal d'erreur n'est généré que si dans un nombre prédéfini de cycles successifs est apparu un nombre prédéfini d'états d'erreur.

9. Procédé selon la revendication 8, **caractérisé en ce que** le nombre prédéterminé de cycles analysés et le nombre prédéterminé d'états d'erreur après lequel est généré un signal d'erreur peuvent être subordonnés :
- au nombre des trains d'impulsions qui ont précédemment été reçus correctement
- au nombre des trains d'impulsions (lA, 1B, 2A, 2B) qui ont précédemment été reçus incorrectement
- au nombre des signaux lumineux,
- au temps de réponse du couple émetteur/récepteur et
- à une machine surveillée par celui-ci.

10. Procédé selon la revendication 9, **caractérisé en ce qu'**une analyse multiple s'effectue du fait que chaque impulsion double (L11, L12, L13, L14, L15, L21, L22, L23, L24, L25) reçue "correctement" incrémente un compteur jusqu'à une valeur maximale fixe prédéterminée et que chaque impulsion double (L11, L12, L13, L14, L15, L21, L22, L23, L24, L25) reçue "incorrectement" décrémente le compteur, un signal d'erreur étant déclenché si le contenu de comptage est décrémenté en dessous d'une valeur de seuil prédéterminée.

11. Procédé selon la revendication 10, **caractérisé en ce que** l'incrémentation et la décrémentation du compteur s'effectuent dans des pas différents.

12. Procédé selon l'une des revendications 1 à 11, **caractérisé en ce que** chaque couple émetteur/récepteur contient un numéro de matricule programmable au moyen duquel sont fixées la durée des trains d'impulsions (1A, 1B, 2A, 2B) et la durée des intervalles entre ceux-ci.

13. Procédé selon l'une des revendications 1 à 12, **caractérisé en ce que** chaque récepteur exécute lors de la première mise en service une recherche de canal automatique d'un canal libre, puis transmet à l'émetteur qui lui est affecté une information sur un canal libre et qu'ensuite le couple émetteur/récepteur attribué se met en phase avec ce canal libre, le couple émetteur/récepteur s'identifiant réciproquement comme allant ensemble, au moyen d'un fonctionnement "shake-hand".
